# EUROPEAN PATENT APPLICATION

(11) **EP 4 730 215 A2**
(43) Date of publication of application: **22.04.2026**
(21) Application number: 26150016.9
(22) Date of filing: 07.01.2022
(51) Int. Cl.: G06N 10/40, H10N 69/00, H10W 20/00, H10W 20/20, H10W 70/63, H10W 90/00, H10W 20/44, H10W 70/66, H10W 90/20

(54) **METHOD FOR MANUFACTURING QUANTUM COMPUTING APPARATUS**

(62) Divisional of application: 22918653.1
(71) Applicant: FUJITSU LIMITED, Kawasaki-shi, Kanagawa 211-8588 (JP)
(72) Inventor: SHIMANOUCHI, Takeaki, Kawasaki-shi, Kanagawa, 211-8588 (JP)
(74) Representative: Hoffmann Eitle

(57) **Abstract**

A quantum computing apparatus (10) includes a plurality of substrates (20, 30, 40) that are stacked and include a substrate (20) on which a qubit device (11) is provided, and through-vias (35A, 35B, 45A, 45B) provided in at least a substrate (40) disposed in an uppermost layer and a substrate (30) disposed in a lowermost layer, among the plurality of substrates (20, 30, 40), and electrically coupled to the substrate (20) disposed in an adjacent layer.

## Description

### FIELD

The disclosed technique relates to a quantum computing apparatus and a method for manufacturing the quantum computing apparatus.

### BACKGROUND

As a technique relating to a quantum computing apparatus, the following techniques are known. For example, a quantum computer system including a plurality of qubit devices arranged in a two-dimensional layout is known, in which at least one internal qubit device of the plurality of qubit devices includes a signal line stretching out of the two-dimensional layout of the plurality of qubit devices. The internal qubit device includes a plurality of layers, a top layer of the plurality of layers includes a through-hole to a bottom layer, and the signal line is placed inside the through-hole to couple the bottom layer to the top layer.

In addition, a quantum device including a first set of protrusions formed on a substrate and a second set of protrusions formed on a qubit chip is also known. The quantum device includes a set of bumps formed on an interposer, where the set of bumps is formed of a material having ductility exceeding a threshold value in an ambient temperature range, and a first subset of the set of bumps is configured for cold welding. On the first set of protrusions, a second subset of the set of bumps is configured for cold welding to the second set of protrusions.

### SUMMARY

### BRIEF DESCRIPTION OF DRAWINGS

FIG. 1 is a partial equivalent circuit diagram of a quantum computing apparatus according to an embodiment of the disclosed technique.
FIG. 2 is a diagram illustrating an example of a coupling configuration between qubit devices according to the embodiment of the disclosed technique.
FIG. 3 is a schematic cross-sectional view illustrating an example of a configuration of the quantum computing apparatus according to the embodiment of the disclosed technique.
FIG. 4 is an exploded view illustrating first to third substrates constituting the quantum computing apparatus according to the embodiment of the disclosed technique.
FIG. 5A is a diagram illustrating an example of a state in which probes are made abutting on the quantum computing apparatus according to the embodiment of the disclosed technique.
FIG. 5B is a diagram illustrating an example of a state in which probes are made abutting on the quantum computing apparatus according to the embodiment of the disclosed technique.
FIG. 6A is a plan view illustrating an example of a form of a seal member according to the embodiment of the disclosed technique.
FIG. 6B is a plan view illustrating a state in which a through-hole constituting a through-via according to the embodiment of the disclosed technique is closed by an electrode.
FIG. 7 is a cross-sectional view illustrating an example of a method for manufacturing the quantum computing apparatus according to the embodiment of the disclosed technique.
FIG. 8 is a cross-sectional view illustrating an example of the method for manufacturing the quantum computing apparatus according to the embodiment of the disclosed technique.
FIG. 9 is a cross-sectional view illustrating an example of the method for manufacturing the quantum computing apparatus according to the embodiment of the disclosed technique.
FIG. 10 is a cross-sectional view illustrating an example of the method for manufacturing the quantum computing apparatus according to the embodiment of the disclosed technique.
FIG. 11 is a cross-sectional view illustrating an example of the method for manufacturing the quantum computing apparatus according to the embodiment of the disclosed technique.
FIG. 12 is a cross-sectional view illustrating an example of the method for manufacturing the quantum computing apparatus according to the embodiment of the disclosed technique.
FIG. 13 is a cross-sectional view illustrating an example of the method for manufacturing the quantum computing apparatus according to the embodiment of the disclosed technique.
FIG. 14 is a cross-sectional view illustrating an example of the method for manufacturing the quantum computing apparatus according to the embodiment of the disclosed technique.
FIG. 15 is a cross-sectional view illustrating an example of the method for manufacturing the quantum computing apparatus according to the embodiment of the disclosed technique.
FIG. 16 is a cross-sectional view illustrating an example of the method for manufacturing the quantum computing apparatus according to the embodiment of the disclosed technique.
FIG. 17 is a cross-sectional view illustrating an example of the method for manufacturing the quantum computing apparatus according to the embodiment of the disclosed technique.
FIG. 18 is a cross-sectional view illustrating an example of the method for manufacturing the quantum computing apparatus according to the embodiment of the disclosed technique.
FIG. 19 is a cross-sectional view illustrating an example of a configuration of a quantum computing apparatus according to another embodiment of the disclosed technique.
FIG. 20 is a cross-sectional view illustrating an example of a configuration of a quantum computing apparatus according to another embodiment of the disclosed technique.
FIG. 21A is a cross-sectional view illustrating an example of a configuration of a quantum computing apparatus according to another embodiment of the disclosed technique.
FIG. 21B is a cross-sectional view illustrating an example of a configuration of a quantum computing apparatus according to another embodiment of the disclosed technique.
FIG. 22 is a cross-sectional view illustrating an example of a configuration of a quantum computing apparatus according to another embodiment of the disclosed technique.

### DESCRIPTION OF EMBODIMENTS

An example of embodiments of the disclosed technique will be described below with reference to the drawings. Note that, in each drawing, the same or equivalent components and portions will be given the same reference signs, and redundant explanation will be omitted.

### [First Embodiment]

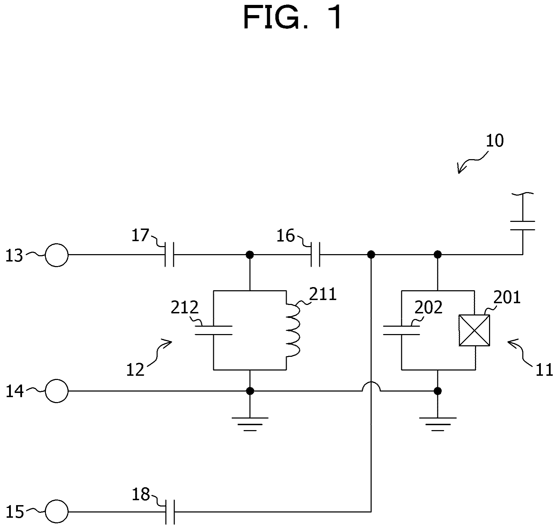

FIG. 1 is a partial equivalent circuit diagram of a quantum computing apparatus 10. The quantum computing apparatus 10 includes a qubit device (qubit) 11, a resonator 12, a read port 13, a ground port 14, and a control port 15.

The qubit device 11 is a device that forms a coherent 2-level system using superconducting and has a configuration including a transmon qubit circuit in which a superconducting Josephson device 201 and a capacitor 202 are coupled in parallel. The superconducting Josephson device 201 has a configuration including a pair of superconductors that exhibit superconductivity at a temperature equal to or lower than a predetermined critical temperature, and an ultrathin insulator having a thickness of about several nanometers (nm) sandwiched between the pair of superconductors. The superconductor may be, for example, aluminum, and the insulator may be, for example, aluminum oxide.

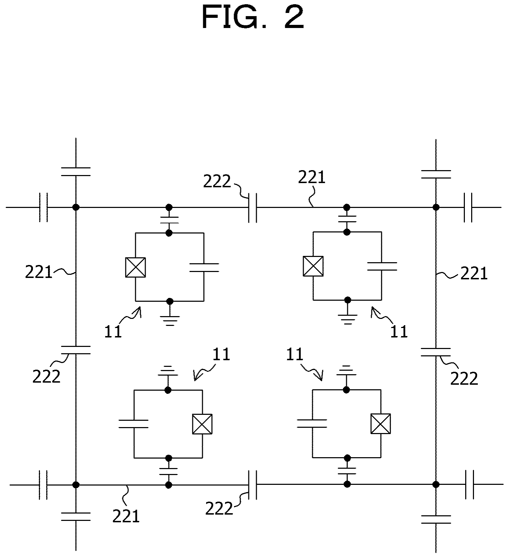

As illustrated in FIG. 2, in the quantum computing apparatus 10, a plurality of qubit devices 11 is coupled to another adjacent qubit device 11 via interbit wire lines 221. Capacitors 222 are provided on paths of the interbit wire lines 221. This ensures that each of the qubit devices 11 creates a quantum entangled state with another adjacent qubit device 11 to perform quantum computation. FIG. 1 illustrates only an excerpt of the configuration in peripheries of one qubit device 11.

The resonator 12 interacts with the qubit device 11, thereby reading a bit signal indicating the state of the qubit device 11. The resonator 12 is coupled to the qubit device 11 via a capacitor 16. The resonator 12 has a configuration including a resonance circuit in which a superconducting inductor 211 and a capacitor 212 are coupled in parallel.

The read port 13, the ground port 14, and the control port 15 are access ports for accessing a quantum computing circuit including the qubit device 11 and the resonator 12 from the outside. The read port 13 is coupled to the resonator 12 via a capacitor 17. The read port 13 is used to extract a bit signal read by the resonator 12 to the outside. The ground port 14 is coupled to the qubit device 11 and the resonator 12. The ground port 14 is used to apply a ground potential to the qubit device 11 and the resonator 12 from the outside. The control port 15 is coupled to the qubit device 11 via a capacitor 18. The control port 15 is used to control the qubit device 11 from the outside.

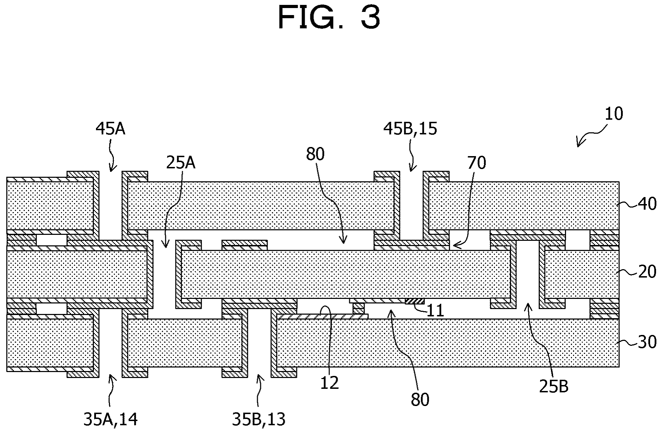

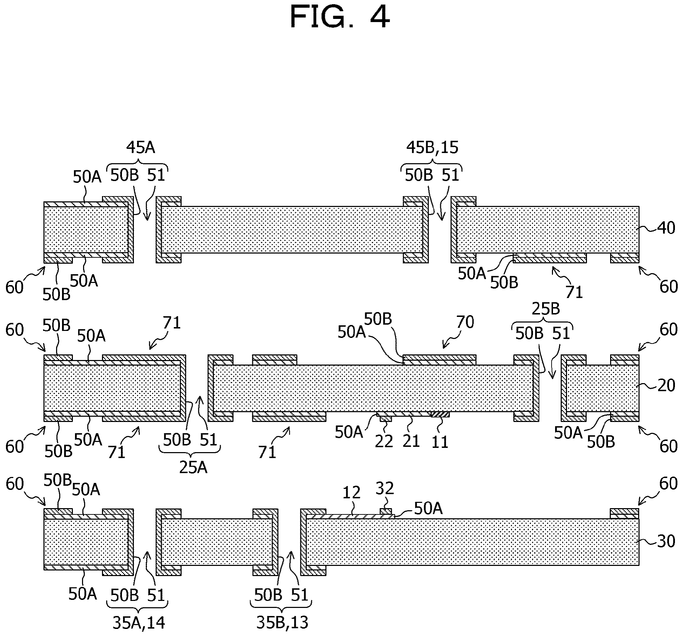

FIG. 3 is a schematic cross-sectional view illustrating an example of a configuration of the quantum computing apparatus 10. FIG. 3 illustrates only an excerpt of the configuration in peripheries of one qubit device 11. The quantum computing apparatus 10 has a configuration in which a first substrate 20, a second substrate 30, and a third substrate 40 are stacked. In the present embodiment, the second substrate 30 is disposed in a lowermost layer, the third substrate 40 is disposed in an uppermost layer, and the first substrate 20 is disposed in an intermediate layer between the uppermost layer and the lowermost layer. FIG. 4 is an exploded view illustrating the first substrate 20, the second substrate 30, and the third substrate 40 to facilitate understanding of the configurations of each of these substrates.

The qubit device 11 is provided on a lower surface of the first substrate 20, and the resonator 12 is provided on an upper surface of the second substrate 30. The resonator 12 is formed by patterning a conductive film 50A. The second substrate 30 is bonded to a lower surface side of the first substrate 20 via a seal member 60 such that the upper surface of the second substrate 30 faces the lower surface of the first substrate 20. The qubit device 11 and the resonator 12 are coupled to each other via a wire line 21 and bumps 22 and 32. The seal member 60 has a configuration including a laminated film in which the conductive film 50A and a conductive film 50B are laminated. The wire line 21 is constituted by the conductive film 50A, and the bumps 22 and 32 are each constituted by the conductive film 50B.

A control electrode 70 to which a control signal for controlling the qubit device 11 is supplied is provided on an upper surface of the first substrate 20. The control electrode 70 is disposed immediately above the qubit device 11, and a control signal supplied to the control electrode 70 is transmitted to the qubit device 11 via a base material of the first substrate 20. The third substrate 40 is bonded to an upper surface side of the first substrate 20 via the seal member 60 such that a lower surface of the third substrate 40 faces the upper surface of the first substrate 20.

Through-vias 25A and 25B are provided in the first substrate 20, through-vias 35A and 35B are provided in the second substrate 30, and through-vias 45A and 45B are provided in the third substrate 40. Each of these through-vias has a configuration including a through-hole 51 passing through the substrate and the conductive film 50B covering an inner wall of the through-hole 51. These through-vias are electrically coupled to an electrode 71 or the control electrode 70 provided on a substrate disposed in an adjacent layer. The control electrode 70 and the other electrodes 71 each has a configuration including a laminated film in which the conductive film 50A and the conductive film 50B are laminated.

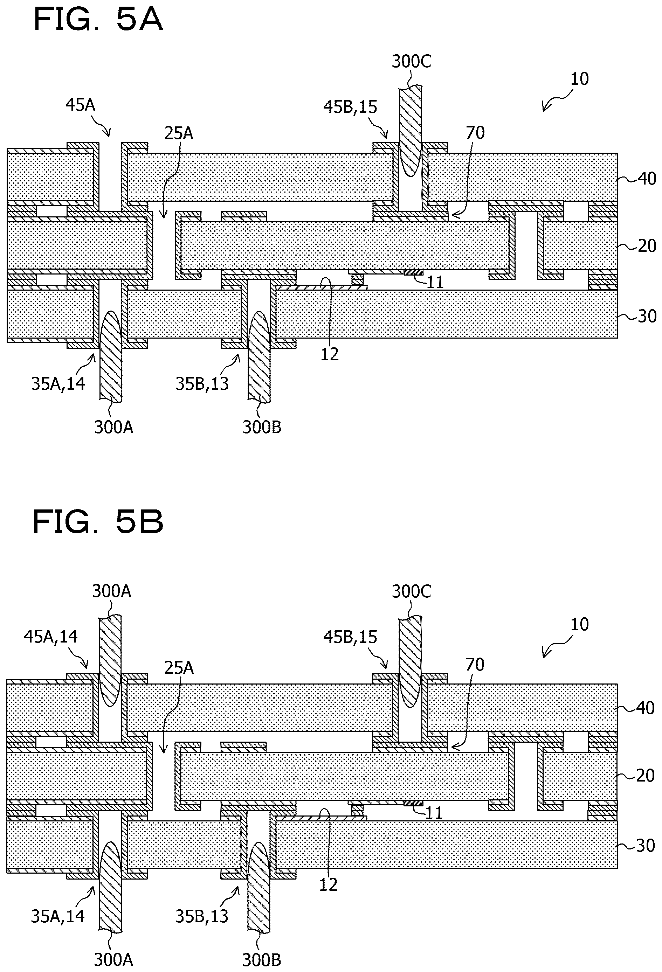

The through-via 35A of the second substrate 30 functions as the ground port 14. That is, when the quantum computing apparatus 10 is used, as illustrated in FIG. 5A, a probe 300A fixed to the ground potential abuts on the through-via 35A. The ground potential supplied from the probe 300A is applied to each element provided on the upper surface and a lower surface of the second substrate 30 by the through-via 35A. The ground potential is also applied to the resonator 12. The through-via 35A is electrically coupled to the through-via 25A of the first substrate 20, and the ground potential is applied to each element provided on the upper surface and the lower surface of the first substrate 20. The ground potential is also applied to the qubit device 11. The through-via 25A is electrically coupled to the through-via 45A of the third substrate 40, and the ground potential is applied to each element provided on an upper surface and the lower surface of the third substrate 40.

Note that both of the through-via 35A of the second substrate 30 and the through-via 45A of the third substrate 40 may function as the ground ports 14. That is, when the quantum computing apparatus 10 is used, as illustrated in FIG. 5B, the probe 300A fixed to the ground potential may abut on each of the through-vias 35A and 45A.

The through-via 35B of the second substrate 30 is electrically coupled to the resonator 12. The through-via 35B functions as the read port 13 for reading a bit signal indicating a state of the qubit device 11. That is, when the quantum computing apparatus 10 is used, as illustrated in FIGs. 5A and 5B, a probe 300B abuts on the through-via 35B, and a bit signal is extracted to the outside by the probe 300B.

The through-via 45B of the third substrate 40 is electrically coupled to the control electrode 70 provided in the first substrate 20. The through-via 45B functions as the control port 15 for controlling the qubit device 11 from the outside. That is, when the quantum computing apparatus 10 is used, as illustrated in FIGs. 5A and 5B, a probe 300C abuts on the through-via 45B, and a control signal for controlling the qubit device 11 supplied from the probe 300C is applied to the control electrode 70 via the through-via 45B. The quantum computing apparatus 10 is used in a vacuum chamber in a state maintained at a cryogenic temperature. The probes 300A, 300B, and 300C can be housed inside a dilution refrigerator together with the quantum computing apparatus 10.

The through-via 25B of the first substrate 20 is used as a gas introduction path for removing a protection film covering a surface of the qubit device 11 in a manufacturing step for the quantum computing apparatus 10. Manufacturing steps for the quantum computing apparatus 10 will be described later.

Spaces 80 are each formed between the first substrate 20 and the second substrate 30 and between the first substrate 20 and the third substrate 40. The space 80 is also formed around the qubit device 11. The through-hole 51 constituting the through-via 25B of the first substrate 20, which is used as a gas introduction path, communicates with the space 80 extending around the qubit device 11.

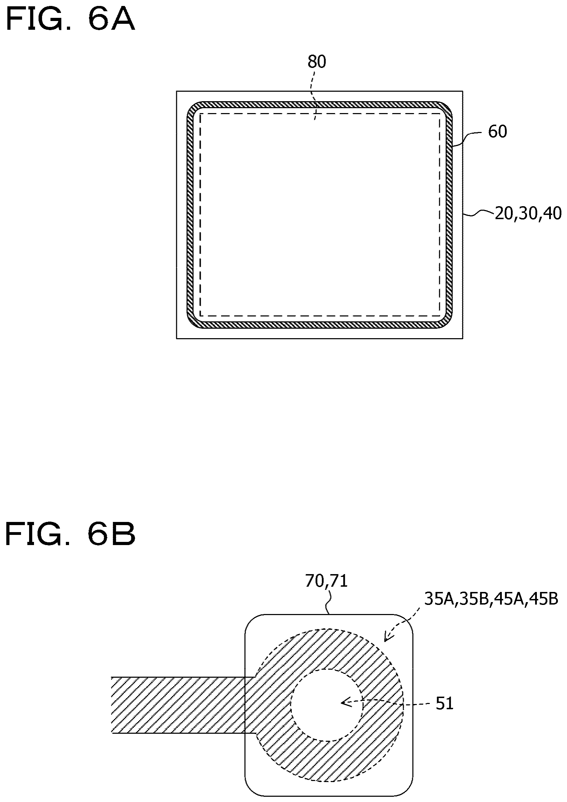

Here, FIG. 6A is a plan view illustrating an example of a form of the seal member 60 that forms a bonding portion between the first substrate 20 and the second substrate 30 and a bonding portion between the first substrate 20 and the third substrate 40. As illustrated in FIG. 6A, the seal member 60 has a ring shape surrounding the space 80 formed between the substrates. In this manner, by bonding the substrates to each other via the ring-shaped seal member 60 surrounding the space 80, the space 80 is brought into a hermetically sealed state. In addition, open ends of the through-holes 51 constituting the through-vias 35A and 35B of the second substrate 30 are closed by the electrodes 71 provided on the lower surface of the first substrate 20. Similarly, open ends of the through-holes 51 constituting the through-vias 45A and 45B of the third substrate 40 are closed by the electrode 71 and the control electrode 70 provided on the upper surface of the first substrate 20. FIG. 6B is a plan view illustrating a state in which the through-holes 51 constituting the through-vias 35A, 35B, 45A, and 45B are each closed by the electrode 71 or the control electrode 70. In this manner, the open ends of the through-holes 51 constituting the through-vias 45A and 45B of the third substrate 40 and the through-vias 35A and 35B of the second substrate 30 are closed by the electrode 71 or the control electrode 70 provided in the first substrate 20, whereby the space 80 is brought into a fully hermetically sealed state.

The hermetically sealed space 80 is preferably vacuum. By evacuating the space 80, adsorption of a substance to the qubit device 11 may be suppressed without forming a protection film that causes dielectric loss on a surface of the qubit device 11, and the surface of the qubit device 11 may be regularly maintained in a clean state. Note that the vacuum is not limited to a full vacuum but includes a low pressure state to such an extent that an effect of substantially suppressing adsorption of a substance to the qubit device 11 is achieved.

The conductive films 50A and 50B constituting each element provided on the first to third substrates are preferably constituted by a metal that exhibits superconductivity at a temperature equal to or lower than a predetermined temperature. Although not particularly limited, for example, titanium nitride (TiN) can be suitably used as the conductive film 50A, and for example, aluminum (Al) can be suitably used as the conductive film 50B.

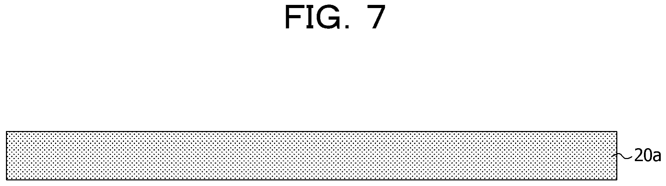

Hereinafter, a method for manufacturing the quantum computing apparatus 10 will be described. Initially, an example of a method for manufacturing the first substrate 20 will be described with reference to FIGs. 7 to 13.

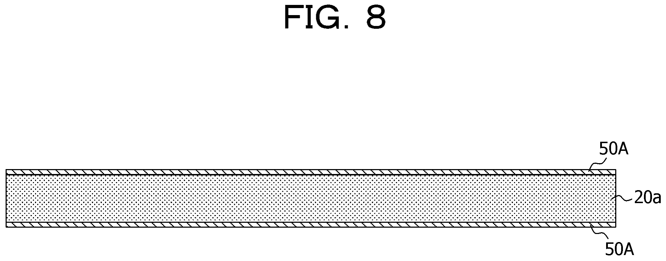

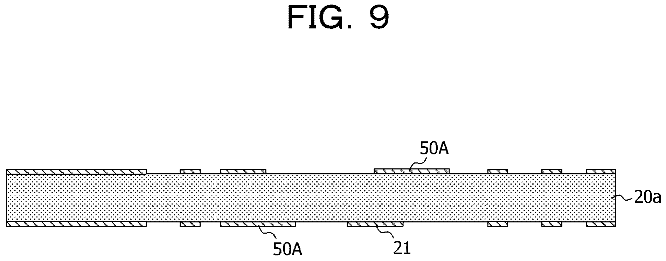

A base material 20a constituting the first substrate 20 is prepared. As the base material 20a, for example, a silicon substrate can be used (FIG. 7). Next, the conductive film 50A is formed on each of an upper surface and a lower surface of the base material 20a by, for example, a vapor deposition method. As the conductive film 50A, for example, titanium nitride (TiN) can be suitably used (FIG. 8). Next, the conductive film 50A is patterned using a known photolithography technique, whereby the wire line 21 and the like are formed (FIG. 9).

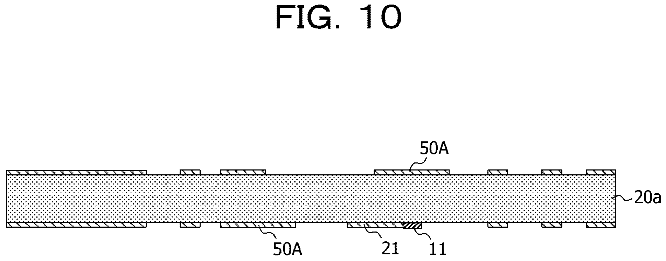

Next, the qubit device 11 is formed on a surface of the base material 20a (FIG. 10). The superconducting Josephson device constituting the qubit device 11 is formed by undergoing, for example, a step of forming a first electrode (not illustrated) containing aluminum (Al) on the surface of the base material 20a by a vapor deposition method, a step of forming an ultrathin oxide film (not illustrated) having a thickness of about several nm on a surface of the first electrode, using an O₂ gas, and a step of forming a second electrode (not illustrated) containing aluminum (Al) on a surface of the oxide film by a vapor deposition method. Patterning for the first electrode and the second electrode may be performed by, for example, a lift-off method using a patterned resist (not illustrated). In this case, an opening pattern of the resist may have a cross shape including a first straight line portion along a first direction and a second straight line portion along a second direction orthogonal to the first direction, and the first electrode may be formed at a portion corresponding to the first straight line portion by performing vapor deposition while being inclined about the first direction as a rotation axis. Subsequently, the second electrode may be formed at a portion corresponding to the second straight line portion by performing vapor deposition while being inclined about the second direction as a rotation axis. According to the above method, patterning for the first electrode and the second electrode can be performed with a single resist.

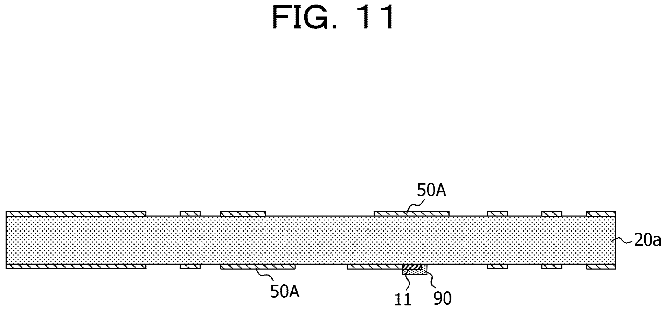

Next, a protection film 90 made of an insulator such as SiO₂ is formed on the surface of the base material 20a by, for example, a chemical vapor deposition (CVD) method. The qubit device 11 is covered with the protection film 90. Next, the protection film 90 is patterned using a known photolithography technique. The protection film 90 is removed except a portion covering the qubit device 11 (FIG. 11).

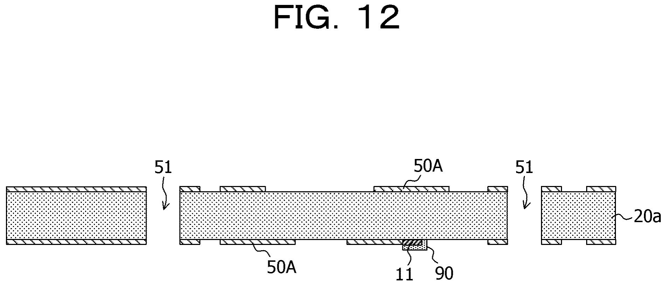

Next, a resist (not illustrated) is formed on the surface of the base material 20a, and this resist is patterned. With the patterned resist as a mask, the through-holes 51 are formed in the base material 20a by, for example, deep reactive ion etching (RIE) (FIG. 12).

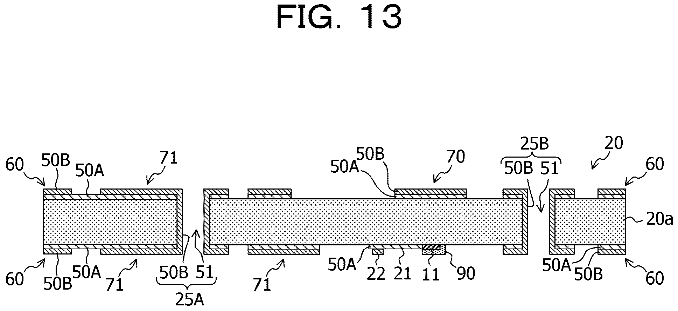

Next, the conductive film 50B is formed on the upper surface and the lower surface of the base material 20a by, for example, a vapor deposition method. Surfaces of the conductive film 50A and inner walls of the through-holes 51 are covered with the conductive film 50B. For example, aluminum (Al) can be suitably used as the conductive film 50B. The conductive film 50B is patterned by, for example, a lift-off method (FIG. 13). On the surface of the base material 20a, the control electrode 70 having a configuration including a laminated film in which the conductive film 50A and the conductive film 50B are laminated, the other electrodes 71, the ring-shaped seal members 60, and the like are formed. In addition, the inner walls of the through-holes 51 are covered with the conductive film 50B, whereby the through-vias 25A and 25B are formed.

The first substrate 20 is completed by undergoing each of the above steps. Since the second substrate 30 and the third substrate 40 are manufactured in a similar way to the first substrate 20, the description of the method for manufacturing these substrates will be omitted.

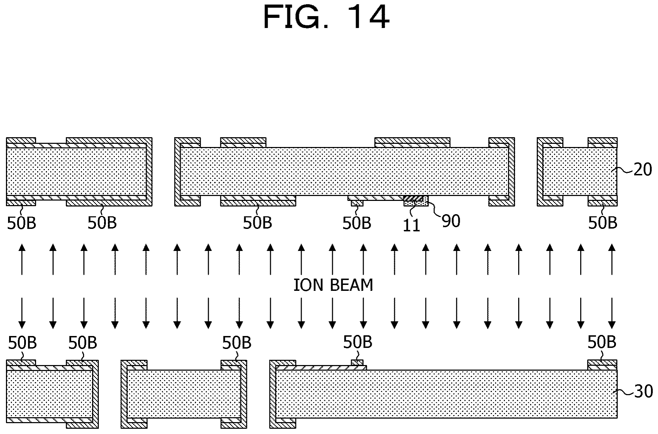

Hereinafter, an example of a method for combining the first substrate 20, the second substrate 30, and the third substrate 40 to form the quantum computing apparatus 10 will be described with reference to FIGs. 14 to 18.

The first substrate 20 and the second substrate 30 are housed in a vacuum chamber (not illustrated), and the lower surface of first substrate 20 and the upper surface of second substrate 30 are irradiated with an ion beam in the vacuum chamber (FIG. 14). This removes elements that hinder bonding, such as the oxide film, a hydroxyl group, and water molecules, present on the surfaces of the conductive film 50B that forms the bonding portion between the first substrate 20 and the second substrate 30 and activates the surfaces of the conductive film 50B. In addition, resist residues and adsorbates present on the surfaces of the first substrate 20 and the second substrate 30 are removed, and the surfaces of the first substrate 20 and the second substrate 30 are cleaned. An inert gas such as argon is used for the ion beam. Since the qubit device 11 is covered with the protection film 90, damage to the qubit device 11 due to ion beam irradiation is suppressed.

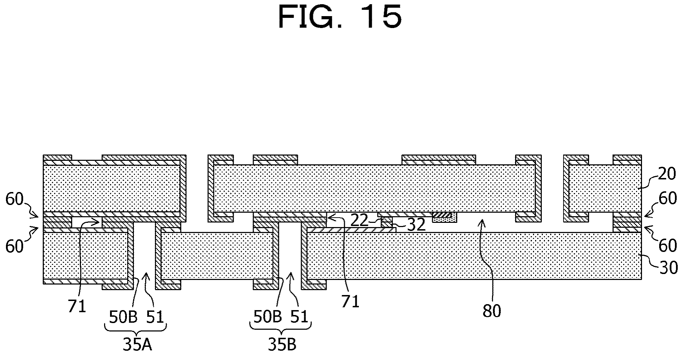

Next, the first substrate 20 and the second substrate 30 are bonded in the vacuum chamber. That is, the seal member 60 on the first substrate 20 and the seal member 60 on the second substrate 30 are bonded, the electrodes 71 on the first substrate 20 and the respective through-vias 35A and 35B of the second substrate 30 are bonded, and the bump 22 on the first substrate 20 and the bump 32 on the second substrate 30 are bonded. Since the surfaces of the conductive film 50B constituting each of these elements are activated by ion beam irradiation, strong bonding can be obtained at room temperature (about 25°C). This approach is called surface-activated room-temperature bonding. By bonding the substrates to each other at room temperature, characteristic fluctuations associated with heating of the qubit device 11 are suppressed. The open ends of the through-holes 51 constituting the through-vias 35A and 35B of the second substrate 30 are closed by the electrodes 71 on the first substrate 20. The first substrate 20 and the second substrate 30 are bonded with a gap interposed therebetween, and the space 80 is formed around the qubit device 11 (FIG. 15).

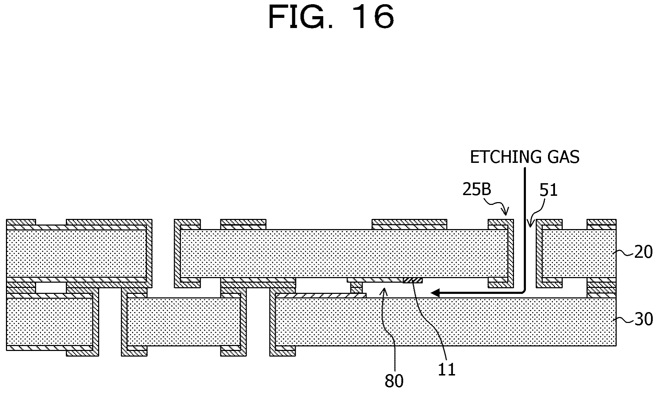

Next, an etching gas such as a vapor HF gas is introduced into the space 80 around the qubit device 11 from the through-hole 51 constituting the through-via 25B of the first substrate 20. This removes the protection film 90 covering the qubit device 11 and also removes a silicon oxide film (SiO₂) formed on the surfaces of the first substrate 20 and the second substrate 30, such that the surfaces of the first substrate 20 and the second substrate 30 are cleaned (FIG. 16).

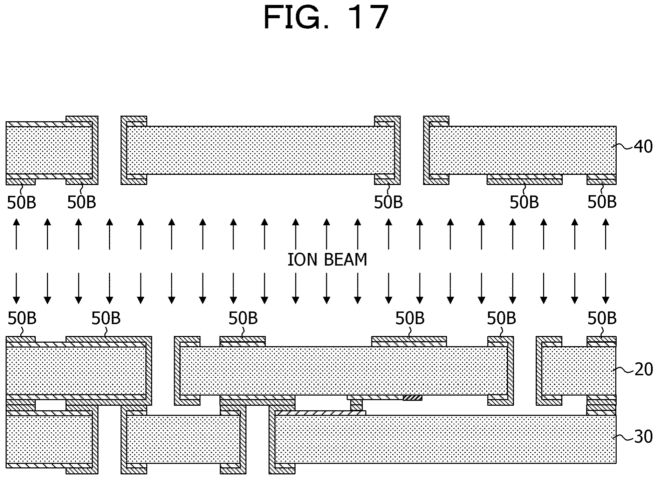

Next, the first substrate 20 and the second substrate 30 bonded to each other, and the third substrate 40 are housed in a vacuum chamber (not illustrated), and the upper surface of the first substrate 20 and the lower surface of the third substrate 40 are irradiated with an ion beam in the vacuum chamber (FIG. 17). This removes elements that hinder bonding, such as the oxide film, a hydroxyl group, and water molecules, present on the surfaces of the conductive film 50B that forms the bonding portion between the first substrate 20 and the third substrate 40 and activates the surfaces of the conductive film 50B. In addition, resist residues and adsorbates present on the surfaces of the first substrate 20 and the third substrate 40 are removed, and the surfaces of the first substrate 20 and the third substrate 40 are cleaned.

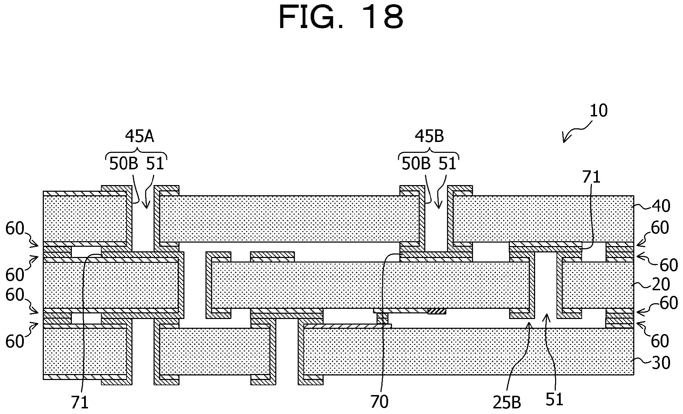

Next, the first substrate 20 and the third substrate 40 are bonded in the vacuum chamber. That is, the seal member 60 on the first substrate 20 and the seal member 60 on the third substrate 40 are bonded, the electrode 71 on the first substrate 20 and the through-via 45A of the third substrate are bonded, the control electrode 70 on the first substrate 20 and the through-via 45B of the third substrate 40 are bonded, and the through-via 25B of the first substrate 20 and the electrode 71 on the third substrate 40 are bonded (FIG. 18). Since the surfaces of the conductive film 50B constituting each of these elements are activated by ion beam irradiation, strong bonding can be obtained at room temperature (about 25°C). The through-via 25B of the first substrate 20 is closed by the electrode 71 on the third substrate 40. In addition, the through-vias 45A and 45B of the third substrate 40 are closed by the electrode 71 and the control electrode 70 on the first substrate 20, respectively. The quantum computing apparatus 10 is completed by undergoing each of the above steps.

As described above, the quantum computing apparatus 10 according to the embodiment of the disclosed technique includes the first substrate 20 provided with the qubit device, the second substrate 30 stacked on the lower surface side of the first substrate 20, and the third substrate 40 stacked on the upper surface side of the first substrate 20. Among these substrates, the second substrate 30 disposed in the lowermost layer is provided with the through-via 35A functioning as the ground port 14 and the through-via 35B functioning as the read port 13. In addition, the third substrate 40 disposed in the uppermost layer is provided with the through-via 45B functioning as the control port 15. The through-via 45A of the third substrate 40 can also be used as the ground port 14. Each of these through-vias 35A, 35B, 45A, and 45B is electrically coupled to the first substrate 20 disposed in the intermediate layer.

When the quantum computing apparatus 10 is used, as illustrated in FIGs. 5A and 5B, the probes 300A to 300C are made abutting on these through-vias 35A, 35B, 45A, and 45B, whereby the quantum computing circuit including the qubit device 11 and the resonator 12 can be accessed. The number of desired probes grows as the number of bits of the quantum computing apparatus 10 grows. As the number of bits increases and the size reduces progressively in the quantum computing apparatus 10, the density of ports rises, and in connection with this, the density of probes rises. This may be likely to generate contact failure between each port and the probes or generate signal crosstalk between the ports.

In the quantum computing apparatus 10 according to the present embodiment, the through-vias 35A, 35B, 45A, and 45B functioning as the access ports on which the probes abut are provided in a distributed manner on two surfaces of the quantum computing apparatus 10. This may enable to suppress an increase in density of the access ports associated with an increase in the number of bits and reduction in size, as compared with a case where the through-vias 35A, 35B, 45A, and 45B are provided only on one surface. In addition, by using both of the through-via 35A of the second substrate 30 and the through-via 45A of the third substrate 40 as the ground ports 14, the ground potential supplied to each unit of the quantum computing apparatus 10 may be made uniform and stabilized.

Here, the time during which the quantum computation can be continued in the qubit device 11 is referred to as coherence time. The coherence time is sensitive to the influence of the state in peripheries of the qubit device 11. For example, when a dielectric such as an oxide film is present in peripheries of the qubit device 11, the coherence time is made shorter due to dielectric loss. Therefore, it is preferable not to form an insulating film such as a protection film on a surface of the qubit device 11. The quantum computing apparatus 10 is maintained at a cryogenic temperature in the vacuum chamber, but an adsorbate adsorbed in the atmosphere, which is a causal factor of decoherence, is cooled as it is and remains. Since the coherence time is shortened by the adsorbate adsorbed on the surface of the qubit device 11, the surface of the qubit device 11 has to be regularly maintained in a clean state. In the quantum computing apparatus 10 according to the present embodiment, the space 80 formed around the qubit device 11 is in a hermetically vacuum-sealed state. This may enable to suppress adsorption of a substance to the qubit device 11 without forming a protection film that causes dielectric loss on a surface of the qubit device 11 and regularly maintain the surface of the qubit device 11 in a clean state.

The superconducting Josephson device 201 constituting the qubit device 11 has characteristics that are likely to fluctuate due to heating. According to the method for manufacturing the quantum computing apparatus 10 according to the present embodiment, both of the bonding between the first substrate 20 and the second substrate 30 and the bonding between the first substrate 20 and the third substrate 40 are performed by surface-activated room-temperature bonding, separately. Accordingly, characteristic fluctuation associated with heating of the qubit device 11 may be avoided. In the surface-activated room-temperature bonding, the surface of each substrate is irradiated with an ion beam. According to the method for manufacturing the quantum computing apparatus 10 according to the present embodiment, the qubit device 11 is covered with the protection film 90 at the time of ion beam irradiation. This may suppress damage to the qubit device 11 due to ion beam irradiation.

In addition, according to the method for manufacturing the quantum computing apparatus 10 according to the present embodiment, the protection film 90 covering the qubit device 11 is removed after the first substrate 20 and the second substrate 30 are bonded. This may enable to exclude a factor that leads to a shortened coherence time.

In addition, according to the method for manufacturing the quantum computing apparatus 10 according to the present embodiment, the protection film 90 is removed by introducing an etching gas from the through-hole 51 communicating with the space 80 formed around the qubit device 11 after bonding the first substrate 20 and the second substrate 30. This may enable to efficiently remove the protection film 90 and clean the surfaces of the first substrate 20 and the second substrate 30.

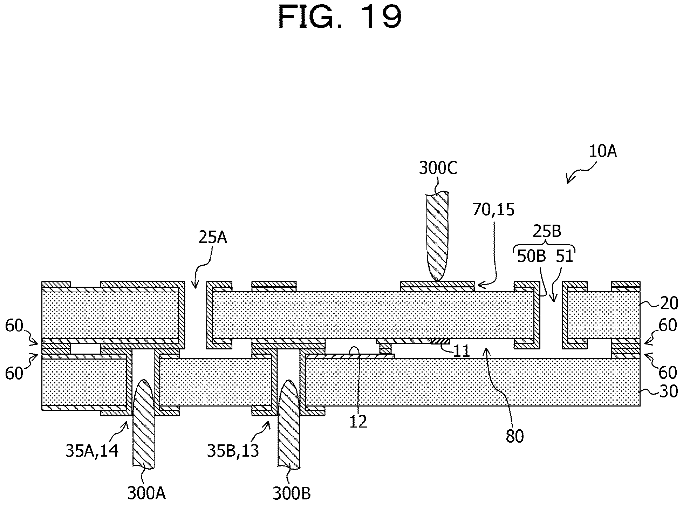

Note that, in the present embodiment, a configuration of the quantum computing apparatus 10 having a three-layer structure in which the first substrate 20, the second substrate 30, and the third substrate 40 are stacked has been exemplified, but the quantum computing apparatus 10 may have a two-layer structure or may have a number of layers equal to or greater than four. FIG. 19 is a schematic cross-sectional view illustrating an example of a configuration of a quantum computing apparatus 10A having a two-layer structure. The quantum computing apparatus 10A is different from the quantum computing apparatus 10 illustrated in FIG. 3 and the like in not including the third substrate 40. That is, in the quantum computing apparatus 10A, the first substrate 20 is disposed in the uppermost layer, the control electrode 70 functions as the control port 15, and the probe 300C abuts on the control electrode 70. In the quantum computing apparatus 10A, the space 80 around the qubit device 11 is exposed to the atmosphere via the through-hole 51 constituting the through-via 25B.

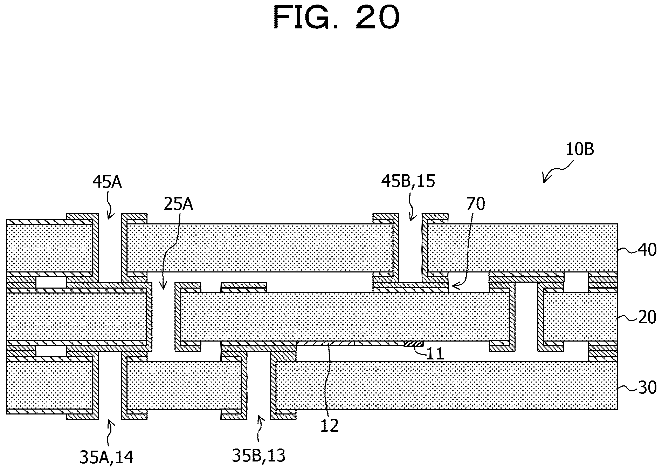

In addition, in the present embodiment, a configuration in which the qubit device 11 is provided in the first substrate 20 and the resonator 12 is provided in the second substrate 30 has been exemplified, but the qubit device 11 and the resonator 12 may be provided on the same substrate. FIG. 20 is a schematic cross-sectional view illustrating an example of a configuration of a quantum computing apparatus 10B in which the qubit device 11 and the resonator 12 are provided in the first substrate 20.

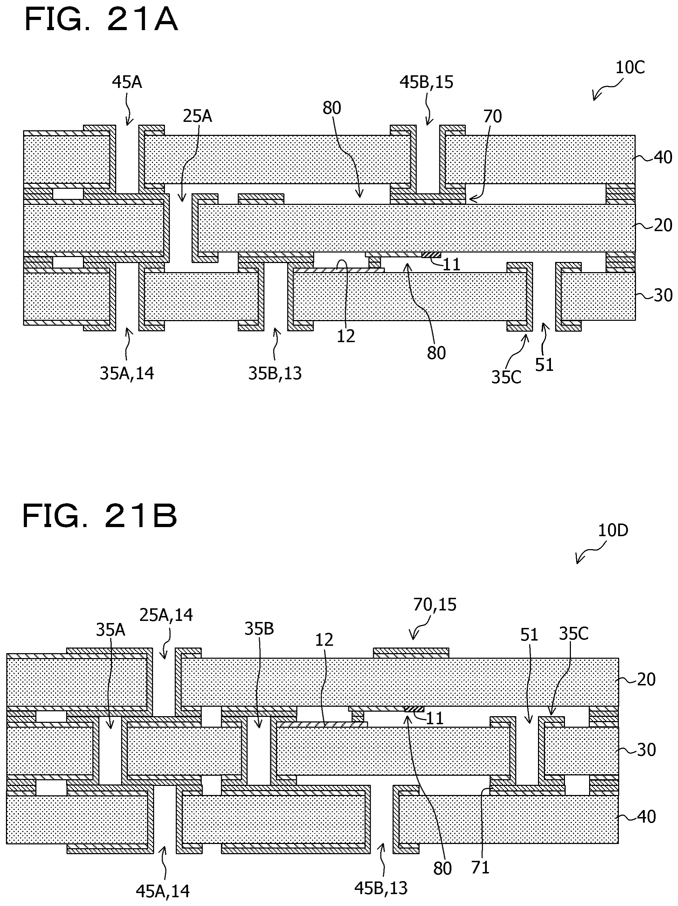

In addition, in the present embodiment, the through-via having the through-hole 51 communicating with the space 80 around the qubit device 11 is provided in the first substrate 20, but the through-via having the through-hole 51 communicating with the space 80 may be provided in a substrate other than the first substrate 20. For example, as in a quantum computing apparatus 10C illustrated in FIG. 21A, the through-hole 51 constituting a through-via 35C provided in the second substrate 30 may communicate with the space 80 around the qubit device 11. In this case, as in a quantum computing apparatus 10D illustrated in FIG. 21B, the third substrate 40 may be bonded to the lower surface side of the second substrate 30, and the open end of the through-hole 51 of the second substrate 30 communicating with the space 80 may be closed by the electrode 71 on the third substrate 40. In the quantum computing apparatus 10D, the through-via 25A of the first substrate 20 disposed in the uppermost layer and the through-via 45A of the third substrate 40 disposed in the lowermost layer each function as the ground port 14. The through-via 45B of the third substrate 40 disposed in the lowermost layer functions as the read port 13. The control electrode 70 on the first substrate 20 disposed in the uppermost layer functions as the control port 15.

### [Second Embodiment]

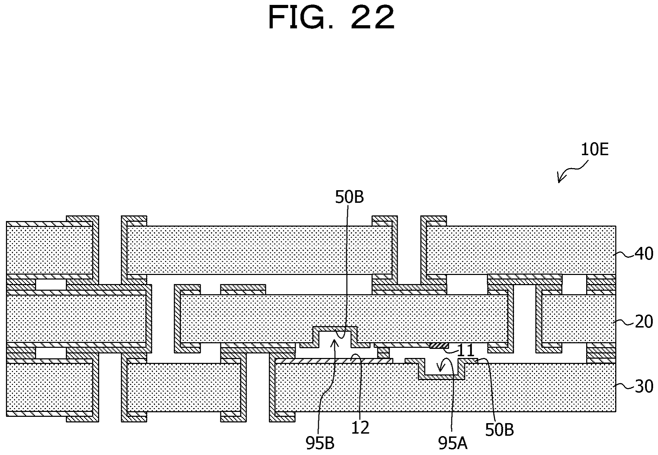

FIG. 22 is a schematic cross-sectional view illustrating an example of a configuration of a quantum computing apparatus 10E according to a second embodiment of the disclosed technique. In the quantum computing apparatus 10E, a second substrate 30 disposed in a layer adjacent to a first substrate 20 on which a qubit device 11 is provided has a recess 95A recessed in a thickness direction of the second substrate 30 at a part facing the qubit device 11. In addition, the first substrate 20 disposed in a layer adjacent to the second substrate 30 on which a resonator 12 is provided has a recess 95B recessed in a thickness direction of the first substrate 20 at a part facing the resonator 12. Surfaces of the recesses 95A and 95B are covered with a conductive film 50B.

In this manner, since the second substrate 30 includes the recess 95A, capacitive coupling between the qubit device 11 and the second substrate 30 may be suppressed. Similarly, since the first substrate 20 includes the recess 95B, capacitive coupling between the resonator 12 and the first substrate 20 may be suppressed. This may stabilize operations of the qubit device 11 and the resonator 12. In addition, the surfaces of the recesses 95A and 95B are covered with the conductive film 50B, whereby exogenous noise affecting operations of the qubit device 11 and the resonator 12 may be suppressed, and diffusion of electromagnetic wave noise radiated from the qubit device 11 and the resonator 12 may also be suppressed.

### CITATION LIST

### PATENT DOCUMENT

Patent Document 1: U.S. Patent Application Publication No. 2019/287946
Patent Document 2: U.S. Patent Application Publication No. 2020/259064

### REFERENCE SIGNS LIST

10, 10A, 10B, 10C, 10D, 10E Quantum computing apparatus
11 Qubit device
12 Resonator
13 Read port
14 Ground port
15 Control port
20 First substrate
25A, 25B Through-via
30 Second substrate
35A, 35B, 35C Through-via
40 Third substrate
45A, 45B Through-via
50A, 50B Conductive film
51 Through-hole
60 Seal member
70 Control electrode
71 Electrode
80 Space
90 Protection film
95A, 95B Recess

Further embodiments are as followed:
E1. A quantum computing apparatus comprising:
   a plurality of substrates that are stacked and include the substrates on which a qubit device is provided;
   a first through-via provided to pass through a first substrate disposed in an uppermost layer, among the plurality of substrates, and electrically coupled to the substrates disposed in a layer adjacent to the first substrate; and
   a second through-via provided to pass through a second substrate disposed in a lowermost layer, among the plurality of substrates, and electrically coupled to the substrates disposed in the layer adjacent to the second substrate.
E2. The quantum computing apparatus according to E1, wherein
   the first through-via is formed in a first through-hole that passes through the first substrate, and the second through-via is formed in a second through-hole that passes through the second substrate, and
   an open end of the first through-hole is closed by the substrates disposed in the layer adjacent to the first substrate, and the open end of the second through-hole is closed by the substrates disposed in the layer adjacent to the second substrate.
E3. The quantum computing apparatus according to E1 or E2, wherein
   a space is formed around the qubit device, and
   a third through-via formed in a third through-hole that passes through a third substrate other than the first substrate and the second substrate among the plurality of substrates and communicates with the space is provided in the third substrate.
E4. The quantum computing apparatus according to E3, wherein
   the space is hermetically sealed and is vacuum.
E5. The quantum computing apparatus according to any one of E1 to E4, wherein
   the substrates disposed in the layer adjacent to the substrates on which the qubit device is provided have a recess at a part that faces the qubit device.
E6. The quantum computing apparatus according to E5, further comprising
   a conductive film that covers a surface of the recess.
E7. The quantum computing apparatus according to any one of embodiments 1 to 6, wherein
   a fourth through-via that functions as a read port intended to read a bit signal that indicates a state of the qubit device, a fifth through-via that functions as a ground port intended to apply a ground potential to the qubit device, and a sixth through-via that functions as a control port intended to control the qubit device are provided in at least one of the first substrate and the second substrate among the plurality of substrates.
E8. A method for manufacturing a quantum computing apparatus, the method comprising:
   cleaning a surface of a first substrate on which a qubit device whose surface is covered with a protection film are provided;
   cleaning a surface of a second substrate;
   bonding the first substrate and the second substrate after cleaning the surface of the first substrate and the surface of the second substrate so as to form a space around the qubit device; and
   removing the protection film by introducing an etching gas into the space via a through-hole provided in at least one of the first substrate and the second substrate.
E9. The method for manufacturing the quantum computing apparatus according to E8, the method further comprising
   bonding a third substrate that closes an open end of the through-hole to the first substrate or the second substrate.
E10. The method for manufacturing the quantum computing apparatus according to E9, wherein
   bonding between substrates for the first substrate, the second substrate, and the third substrate is each performed in a vacuum to hermetically seal the space.
E11. The method for manufacturing the quantum computing apparatus according to any one of embodiments 8 to 10,
   the method further comprising:
   forming through-vias in each of two substrates among a plurality of substrates that includes the first substrate and the second substrate; and
   stacking the plurality of substrates such that the two substrates in which the through-vias are formed are disposed separately in an uppermost layer and a lowermost layer; wherein
   the through-vias are electrically coupled to the substrates each disposed in a layer adjacent to the two substrates.
E12. The method for manufacturing the quantum computing apparatus according to any one of embodiments 8 to 11, wherein
   in the cleaning the surface of the first substrate and the cleaning the surface of the second substrate, the surface of the first substrate and the surface of the second substrate are irradiated with an ion beam.
E13. The method for manufacturing the quantum computing apparatus according to E12, wherein
   conductive films are provided in the first substrate and the second substrate, and
   the first substrate and the second substrate are bonded by room-temperature bonding between the conductive films each of which has the surface activated by irradiation with the ion beam.

## Claims

1. A method for manufacturing a quantum computing apparatus, the method comprising:
cleaning a surface of a first substrate on which a qubit device whose surface is covered with a protection film are provided;
cleaning a surface of a second substrate;
bonding the first substrate and the second substrate after cleaning the surface of the first substrate and the surface of the second substrate so as to form a space around the qubit device; and
removing the protection film by introducing an etching gas into the space via a through-hole provided in at least one of the first substrate and the second substrate.

2. The method for manufacturing the quantum computing apparatus according to claim 1, the method further comprising
bonding a third substrate that closes an open end of the through-hole to the first substrate or the second substrate.

3. The method for manufacturing the quantum computing apparatus according to claim 2, wherein
bonding between substrates for the first substrate, the second substrate, and the third substrate is each performed in a vacuum to hermetically seal the space.

4. The method for manufacturing the quantum computing apparatus according to any one of claims 1 to 3,
the method further comprising:
forming through-vias in each of two substrates among a plurality of substrates that includes the first substrate and the second substrate; and
stacking the plurality of substrates such that the two substrates in which the through-vias are formed are disposed separately in an uppermost layer and a lowermost layer; wherein
the through-vias are electrically coupled to the substrates each disposed in a layer adjacent to the two substrates.

5. The method for manufacturing the quantum computing apparatus according to any one of claims 1 to 4, wherein
in the cleaning the surface of the first substrate and the cleaning the surface of the second substrate, the surface of the first substrate and the surface of the second substrate are irradiated with an ion beam.

6. The method for manufacturing the quantum computing apparatus according to claim 5, wherein
conductive films are provided in the first substrate and the second substrate, and the first substrate and the second substrate are bonded by room-temperature bonding between the conductive films each of which has the surface activated by irradiation with the ion beam.
